# EUROPEAN PATENT APPLICATION

(11) **EP 3 444 374 A2**
(43) Date of publication of application: **20.02.2019**
(21) Application number: 18188637.5
(22) Date of filing: 13.08.2018
(51) Int. Cl.: C23C 14/52, C23C 14/54, C23C 14/56, H01L 31/18

(54) **TEMPERATURE MEASURING METHOD AND SYSTEM FOR THIN FILM SOLAR CELL PROCESS DEVICE**

(30) Priority: 16.08.2017 CN 201710702555
(71) Applicant: Beijing Juntai Innovation Technology Co., Ltd, 100176 Beijing (CN)
(72) Inventor: Mengshi, ZHANG, Beijing, 100176 (CN)
(74) Representative: Nony

(57) **Abstract**

A temperature measuring method and system for a thin film solar cell process device are provided. The method includes: sending a temperature measuring apparatus into a feeding chamber, a heating chamber, a process chamber, a cooling chamber and a discharging chamber of the thin film solar cell process device in sequence, and measuring and storing a current temperature of each heating zone in the heating chamber, the process chamber and the cooling chamber in sequence; and comparing the current temperature with a preset temperature, and adjusting a heating temperature of a heater of each heating zone in the heating chamber, the process chamber and the cooling chamber according to a comparison result.

## Description

### TECHNICAL FIELD

The present disclosure relates to a device and a method for manufacturing a solar cell, and for example, relates to a temperature measuring method and temperature measuring system for a thin film cell process device.

### BACKGROUND

Temperature is one of important parameters in a preparation process of a thin film solar cell. Manufacturing devices of the thin film solar cell include a Physical Vapor Deposition (PVD) device and a Copper Indium Gallium Selenium (CIGS) evaporation device which are both plate type and have multi chambers. There are different process temperature requirements in different chambers, different areas of a same chamber.

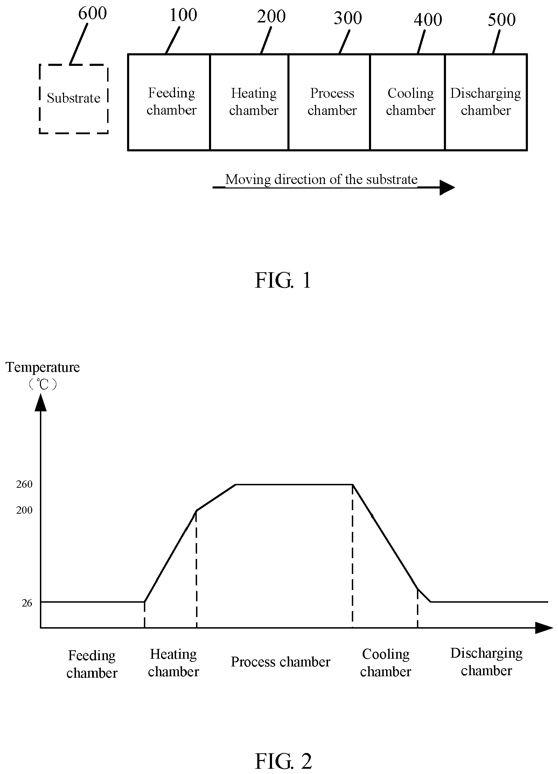

FIG. 1 is a diagram illustrating a simplified structural of a plate type multi-chamber process device in a relevant technology. As shown in FIG. 1, the plate type multi-chamber process device in the relevant technology includes a feeding chamber 100, a heating chamber 200, a process chamber 300, a cooling chamber 400 and a discharging chamber 500.

A solar cell substrate 600 enters the process device through the feeding chamber 100 (at room temperature). After being heated to 200°C in the heating chamber 200, the solar cell substrate 600 enters the process chamber 300. The solar cell substrate 600 is further heated to 260°C in the process chamber 300, and a thin film deposition is performed on the solar cell substrate 600. After the process is ended, the solar cell substrate 600 enters the cooling chamber 400, then is cooled to the room temperature, and is finally outputted from the device through the discharging chamber 500. The temperatures of various chambers are shown in FIG. 2.

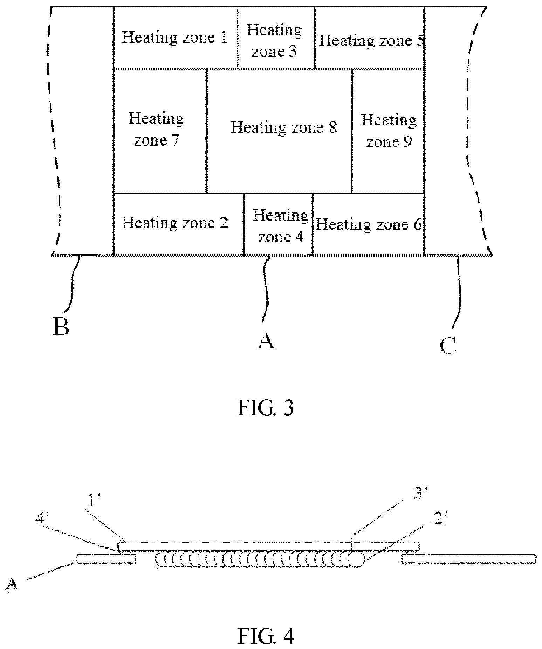

In consideration of a temperature difference caused by factors such as an edge of the chamber, a center of the chamber, a heat dissipation environment and the like, the chamber for heating includes different heating regions. As shown in FIG. 3, the heating chamber 200 (region A), which is taken as an example, includes a plurality of heating regions having different temperatures. Each heating region is a heating zone. Region B and region C are other chambers adjacent to the heating chamber 200. Each heating zone is provided with a heater. The heaters of the heating zones 7, 8 and 9 are main heaters, and the heaters of the heating zones from 1 to 6 are edge heaters. Since each heating zone is next to the external environment, each heating zone has a different heat dissipation effect, and the edge heaters mainly play a heat preservation role. As shown in FIG. 4, each of the above-mentioned heaters includes a top cover 1', a heating wire 2', a thermocouple 3' and sealing pads 4'. After the heater is heated by supplied power, the temperature of the heater is measured by the thermocouple 3', and then is transmitted into a controller for controlling chamber temperature.

In the relevant technology, the thermocouple 3' enters the chamber where each heating zone is arranged through a vacuum sealing flange to get close to, come into contact with or get wound around the heater to measure the temperature. With these mounting manners, the temperature measurement is inaccurate, and the reading of the thermocouple 3' is close to the temperature of the heating wire, and cannot accurately reflect the temperature of the chamber.

### SUMMARY

The present disclosure provides a temperature measuring method and system for a thin film solar cell process device to solve the problems in the relevant technology and accurately reflect temperatures of chambers of the process device, so as to improve the machining quality of a thin film solar cell.

The present disclosure provides a temperature measuring method for the thin film solar cell process device. The method includes:
sending a temperature measuring apparatus into a feeding chamber, a heating chamber, a process chamber, a cooling chamber and a discharging chamber of the thin film solar cell process device in sequence, and measuring and storing a current temperature of each heating zone in the heating chamber, the process chamber and the cooling chamber; and
comparing the current temperature of each heating zone with a preset temperature, and adjusting a heating temperature of a heater of each heating zone in the heating chamber, the process chamber and the cooling chamber according to a comparison result.

In an exemplary embodiment, the step of sending a temperature measuring apparatus into a feeding chamber, a heating chamber, a process chamber, a cooling chamber and a discharging chamber of the thin film solar cell process device in sequence, and measuring and storing a current temperature of each heating zone in the heating chamber, the process chamber and the cooling chamber includes:
conveying the temperature measuring apparatus to the feeding chamber at a first preset speed;
conveying the temperature measuring apparatus to the heating chamber at a second preset speed, and measuring and storing the current temperature of each heating zone in the heating chamber; and
detecting first process parameters in the heating chamber, conveying the temperature measuring apparatus to the process chamber at a third preset speed if the first process parameters reach preset values, and measuring and storing the current temperature of each heating zone in the process chamber, wherein the first process parameters comprise a flow, a temperature and a pressure of gas in the heating chamber.

In an exemplary embodiment, after measuring and storing the current temperature of each heating zone in the process chamber, the method further includes:
detecting second process parameters in the process chamber, conveying the temperature measuring apparatus to the cooling chamber at a fourth preset speed if the second process parameters reach preset values, and measuring and storing the current temperature of each heating zone in the cooling chamber, wherein the second process parameters comprises a flow, a temperature and a temperature of gas in the process chamber.

In an exemplary embodiment, after measuring and storing the current temperature of each heating zone in the cooling chamber, the method further includes:
detecting third process parameters in the cooling chamber, and conveying the temperature measuring apparatus to the discharging chamber at a fifth preset speed when the third process parameters reach preset values, wherein the third process parameters comprises a flow, a temperature and a pressure of gas in the cooling chamber.

In an exemplary embodiment, after the step of comparing the current temperature of each heating zone with the preset temperature, and adjusting the heating temperature of the heater of each heating zone in the heating chamber, the process chamber and the cooling chamber according to the comparison result, the method further includes:
detecting a temperature of the heater, and cutting off a power and sounding an alarm when the temperature of the heater is greater than a first limit value or lower than a second limit value.

The present disclosure further provides a temperature measuring system for a thin film solar cell process device. The system includes a temperature measuring apparatus, a storage apparatus and a control apparatus.

The temperature measuring apparatus is configured to pass a feeding chamber, a heating chamber, a process chamber, a cooling chamber and a discharging chamber of the thin film solar cell process device in sequence, and measure a current temperature of each heating zone in the heating chamber, the process chamber and the cooling chamber in sequence.

The storage apparatus is configured to store the current temperature measured by the temperature measuring apparatus.

The control apparatus is configured to compare the current temperature of each heating zone with a preset temperature, and adjust a heating temperature of a heater of each heating zone in the heating chamber, the process chamber and the cooling chamber according to a comparison result.

In an exemplary embodiment, the temperature measuring system further includes a conveying apparatus configured to convey the temperature measuring apparatus.

In an exemplary embodiment, the temperature measuring system further includes a plurality of sensors. The plurality of sensors are configured to detect first process parameters of the heating chamber, second process parameters of the process chamber and third process parameters of the cooling chamber.

In an exemplary embodiment, the temperature measuring apparatus includes a measuring plate and one or more thermocouples. A shape and sizes of the measuring plate are the same as a shape and sizes of a solar cell substrate to be processed. The one or more thermocouples are arranged on the measuring plate.

In an exemplary embodiment, a plurality of thermocouples are provided. Each of the plurality of thermocouples is located at a position on the measuring plate corresponding to a respective heating zone of each chamber.

The temperature measuring method and system for the thin film solar cell process device provided by the present disclosure measure the current temperature of each heating zone in the heating chamber, the process chamber and the cooling chamber through the temperature measuring apparatus, and store the current temperature in the storage apparatus. The heating temperature of the heater is adjusted if the current temperature does not accord with a temperature parameter required by each heating zone in the heating chamber, the process chamber and the cooling chamber, so as to increase or decrease the heating temperature of the heater. In this way, in a subsequent solar cell substrate processing, the temperature of each chamber is adjusted to a proper range, and the processing quality of the thin film solar cell is improved.

### BRIEF DESCRIPTION OF DRAWINGS

FIG. 1 is a diagram illustrating a simplified structure of a plate type multi-chamber process device in the relevant technology;
FIG. 2 illustrates a heating temperature of each chamber;
FIG. 3 is a diagram illustrating a simplified structure of heating zones in each chamber;
FIG. 4 is a structural schematic diagram of a heater in the relevant technology;
FIG. 5 is a flow chart of a temperature measuring method for a thin film solar cell process device provided by an embodiment;
FIG. 6 is a flow chart of a temperature measuring method for a thin film solar cell process device provided by an embodiment; and
FIG. 7 is a structural schematic diagram of a measuring apparatus.

### List of reference numerals

100-feeding chamber; 200-heating chamber; 300-process chamber; 400-cooling chamber; 500-discharging chamber; 600-solar cell substrate; 1'-top cover; 2'-heating wire; 3'-thermocouple; 4'-sealing pad; 1-measuring apparatus; 11-measuring plate; 12-thermocouple; 2-storage apparatus; 3-conveying apparatus; and 4-sensor.

### DETAILED DESCRIPTION

Embodiments of the present disclosure are described in detail below. Examples of described embodiments are shown in accompanying drawings. Same or similar numerals represent same or similar elements throughout or elements with same or similar functions. Embodiments described below by referring to drawings are exemplary, are only used to explain the present disclosure and shall not be construed as a limitation to the present disclosure.

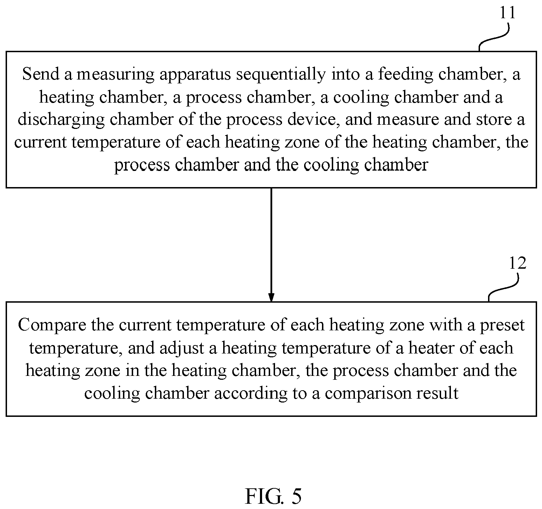

As shown in FIG. 5, an embodiment provides a temperature measuring method for a thin film solar cell process device. The method includes step 11 and step 12.

In step 11, a temperature measuring apparatus is sent into a feeding chamber, a heating chamber, a process chamber, a cooling chamber and a discharging chamber of the process device in sequence, and a current temperature of each heating zone in the heating chamber, the process chamber and the cooling chamber is measured and stored.

In step 12, the current temperature of each heating zone is compared with a preset temperature, and a heating temperature of a heater of each heating zone in the heating chamber, the process chamber and the cooling chamber is adjusted according to a comparison result.

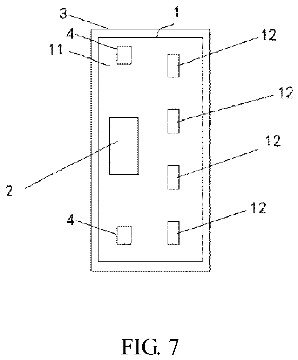

The temperature measuring apparatus may be obtained by further manufacturing a solar cell substrate to be processed. With reference to FIG. 7, the measuring apparatus 1 includes a measuring plate 11 and thermocouples 12. The shape and sizes of the measuring plate 11 are the same as the shape and sizes of the solar cell substrate to be processed. The thermocouples 12 are arranged on the measuring plate 11.

The current temperature of each heating zone in the heating chamber, the process chamber and the cooling chamber is reflected by recording temperatures of the thermocouples 12, and the current temperatures are stored in the storage apparatus. A heating temperature of a heater is adjusted if the current temperature does not accord with a temperature parameter required by each heating zone in the heating chamber, the process chamber and the cooling chamber, so as to increase or decrease the temperature. In this way, in the subsequent solar cell substrate process, the temperature of each chamber and the temperature of each heating zone are adjusted to be in proper ranges, and the processing quality of the thin film solar cell is improved.

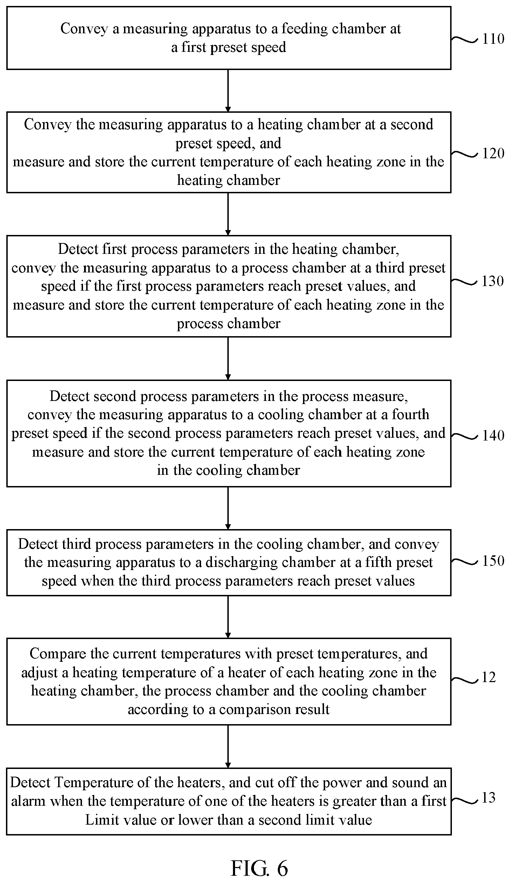

FIG. 6 is a flow chart illustrating a temperature measuring method for a thin film solar cell process device provided by an embodiment. As shown in FIG. 6, the temperature measuring apparatus is sent into the feeding chamber, the heating chamber and the process chamber of the process device in sequence, and the current temperature of each heating zone in the heating chamber and the process chamber are measured and stored in sequence. The above process includes the following steps.

In step 110, the temperature measuring apparatus is conveyed to the feeding chamber at a first preset speed.

In step 120, the temperature measuring apparatus is conveyed to the heating chamber at a second preset speed, and the current temperature of each heating zone in the heating chamber is measured and stored.

In step 130, first process parameters in the heating chamber are detected, the temperature measuring apparatus is conveyed to the process chamber at a third preset speed if the first process parameters reach preset values, and the current temperature of each heating zone in the process chamber is measured and stored. The first process parameters include a pressure, a temperature and a flow of gas in the heating chamber.

Those skilled in the art should understand that the temperature measuring apparatus is conveyed into the feeding chamber at an uninterrupted preset speed. To make use of a control rhythm of a production line, the temperature measuring apparatus is conveyed through the above chambers without stopping. After the temperature measuring apparatus enters the heating chamber, the first process parameters in the heating chamber are detected by sensors. The first process parameters may include the pressure, the temperature and the flow of the gas, and may further include other parameters. These parameters are set according to parameters required by the solar cell substrate in the actual production. When the first process parameters satisfy conditions, the temperature measuring apparatus is conveyed into the process chamber.

In an embodiment, after the current temperature of each heating zone in the process chamber is measured and stored, the method further includes step S140.

In step 140, second process parameters in the process chamber are detected, the temperature measuring apparatus is conveyed to the cooling chamber at a fourth preset speed if the second process parameters reach preset values, and the current temperature of each heating zone in the cooling chamber is measured and stored. The second process parameters include a pressure, a temperature and a flow of gas in the process chamber.

In an embodiment, after the current temperature of each heating zone in the cooling chamber is measured and stored, the method further includes step 150.

In step 150, third process parameters in the cooling chamber are detected, and the temperature measuring apparatus is conveyed to the discharging chamber at a fifth preset speed when the third process parameters reach preset values. The third process parameters include a pressure, a temperature and a flow of gas in the cooling cavity.

Since deposition and other reactions need to be performed on the solar cell substrate in the heating chamber, the process chamber and the cooling chamber, the sensors are used to detect the process parameters of the above-mentioned three chambers, so as to control the stay time of the temperature measuring apparatus.

The above-mentioned first preset speed, second preset speed, third preset speed, fourth preset speed and fifth preset speed may be the same, or may be configured as different speeds according to actual needs.

On the basis of above embodiments, the method may further include step 13.

In step 13, a temperature of the heater is detected, and the power is cut off and an alarm is sounded when the temperature of the heater is greater than a first limit value or lower than a second limit value.

After the temperature of each chamber is stabilized, the temperature measuring apparatus enters the thin film solar cell process device through the feeding chamber, and moves out to the discharging chamber. In the whole process, temperatures of the thermocouples on the measuring plate are recorded, and then are stored in the storage apparatus. The storage apparatus may be a data register embedded into the measuring plate. The temperature data are compared with the required temperatures in the process parameters. If the data meet the needs of the process parameters, a reading number of each thermocouple is used as a reference temperature at this time. If the data do not meet the requirements, temperature settings of the heaters in the corresponding heating regions are adjusted. If the temperature of the heater is greater than a first limit value or lower than a lower limit value, the alarm is sounded to remind an operator of maintenance.

Embodiments of the present disclosure further provide a temperature measuring system for a thin film solar cell process device. The temperature measuring system includes a temperature measuring apparatus, a storage apparatus and a control apparatus.

The temperature measuring apparatus is configured to pass the feeding chamber, the heating chamber, the process chamber, the cooling chamber and the discharging chamber of the thin film solar cell process device in sequence, and measure a current temperature of each heating zone in the heating chamber, the process chamber and the cooling chamber in sequence. The storage apparatus is configured to store the current temperature measured by the temperature measuring apparatus. The control apparatus is configured to compare the current temperature with a preset temperature, and adjust a heating temperature of a heater of each heating zone in the heating chamber, the process chamber and the cooling chamber according to a comparison result.

In an embodiment, with reference to FIG. 7, the temperature measuring apparatus 1 includes a temperature measuring plate 11 and one or more thermocouples 12. The shape and sizes of the temperature measuring plate 11 are the same as the shape and sizes of a solar cell substrate to be processed. The one or more thermocouples 12 are arranged on the temperature measuring plate 11. The storage apparatus 2 may be a data register embedded into the temperature measuring plate 11. Since the heating chamber, the process chamber and the cooling chamber each include multiple heating zones, the temperature measuring apparatus 1 includes multiple thermocouples 12. Each of the multiple thermocouples 12 is located at a position on the temperature measuring plate corresponding to a respective one of the multiple heating zones, so as to make temperature detection to be more accurate.

On the basis of above embodiments, the temperature measuring system provided by embodiments of the present disclosure further includes a conveying apparatus 3 configured to convey the temperature measuring apparatus 1 and convey the temperature measuring apparatus 1 to pass through the above chambers at preset speeds.

In an embodiment, the temperature measuring system provided by embodiments of the present disclosure further includes a plurality of sensors 4. The plurality of sensors 4 are configured to detect the above-mentioned first process parameters, second process parameters and third process parameters.

## Claims

1. A temperature measuring method for a thin film solar cell process device, comprising:
sending (11) a temperature measuring apparatus into a feeding chamber, a heating chamber, a process chamber, a cooling chamber and a discharging chamber of the thin film solar cell process device in sequence, and measuring and storing a current temperature of each heating zone in the heating chamber, the process chamber and the cooling chamber; and co
mparing (12) the current temperature of each heating zone with a preset temperature, and adjusting a heating temperature of a heater of each heating zone in the heating chamber, the process chamber and the cooling chamber according to a comparison result.

2. The temperature measuring method according to claim 1, wherein the sending the temperature measuring apparatus into the feeding chamber, the heating chamber and the process chamber of the thin film solar cell process device in sequence, and measuring and storing the current temperature of each heating zone in the heating chamber and the process chamber comprises:
conveying (110) the temperature measuring apparatus to the feeding chamber at a first preset speed;
conveying (120) the temperature measuring apparatus to the heating chamber at a second preset speed, and measuring and storing the current temperature of each heating zone in the heating chamber; and
detecting (130) first process parameters in the heating chamber, conveying the temperature measuring apparatus to the process chamber at a third preset speed if the first process parameters reach preset values, and measuring and storing the current temperature of each heating zone in the process chamber, wherein the first process parameters comprise a flow, a temperature and a pressure of gas in the heating chamber.

3. The temperature measuring method according to claim 2, after measuring and storing the current temperature of each heating zone in the process chamber, further comprising:
detecting (140) second process parameters in the process chamber, conveying the temperature measuring apparatus to the cooling chamber at a fourth preset speed if the second process parameters reach preset values, and measuring and storing the current temperature of each heating zone in the cooling chamber, wherein the second process parameters comprises a flow, a temperature and a temperature of gas in the process chamber.

4. The temperature measuring method according to claim 3, after measuring and storing the current temperature of each heating zone in the cooling chamber, further comprising:
detecting (150) third process parameters in the cooling chamber, and conveying the temperature measuring apparatus to the discharging chamber at a fifth preset speed when the third process parameters reach preset values, wherein the third process parameters comprises a flow, a temperature and a pressure of gas in the cooling chamber.

5. The temperature measuring method according to any one of claims 1 to 4, after comparing the current temperature of each heating zone with the preset temperature, and adjusting the heating temperature of the heater of each heating zone in the heating chamber, the process chamber and the cooling chamber according to the comparison result, further comprising:
detecting (13) a temperature of the heater, and cutting off a power and sounding an alarm when the temperature of the heater is greater than a first limit value or lower than a second limit value.

6. A temperature measuring system for a thin film solar cell process device, comprising a temperature measuring apparatus (1), a storage apparatus (2) and a control apparatus, wherein
the temperature measuring apparatus (1) is configured to pass a feeding chamber (100), a heating chamber (200), a process chamber (300), a cooling chamber (400) and a discharging chamber (500) of the thin film solar cell process device in sequence, and measure a current temperature of each heating zone in the heating chamber (200), the process chamber (300) and the cooling chamber (400) in sequence;
the storage apparatus (2) is configured to store the current temperature measured by the temperature measuring apparatus (1); and
the control apparatus is configured to compare the current temperature of each heating zone with a preset temperature, and adjust a heating temperature of a heater of each heating zone in the heating chamber (200), the process chamber (300) and the cooling chamber (400) according to a comparison result.

7. The temperature measuring system according to claim 6, further comprising a conveying apparatus (3) configured to convey the temperature measuring apparatus (1).

8. The temperature measuring system according to claim 7, further comprising a plurality of sensors (4) configured to detect first process parameters of the heating chamber (200), second process parameters of the process chamber (300) and third process parameters of the cooling chamber (400).

9. The temperature measuring system according to any one of claims 6 to 8, wherein the temperature measuring apparatus (1) comprises a measuring plate (11) and one or more thermocouples (12), a shape and sizes of the measuring plate (11) are the same as a shape and sizes of a solar cell substrate (600) to be processed, and the one or more thermocouples (12) are arranged on the measuring plate (11).

10. The temperature measuring system according to claim 9, wherein the temperature measuring apparatus (1) comprises a plurality of thermocouples (12); and each of the plurality of thermocouples (12) is located at a position, corresponding to a respective heating zone of each cavity, on the measuring plate (11).
